# EUROPEAN PATENT APPLICATION

(11) **EP 3 336 727 A1**
(43) Date of publication of application: **20.06.2018**
(21) Application number: 16306727.5
(22) Date of filing: 19.12.2016
(51) Int. Cl.: G06F 17/50

(54) **SYSTEM AND METHOD FOR DEFINING A PROGRAMMABLE LOGIC ARCHITECTURE**

(71) Applicant: MENTA, 34000 Montpellier (FR)
(72) Inventor: ROUGE, Laurent, 34920 LE CRES (FR); DEXET, Martine, 34920 LE CRES (FR)
(74) Representative: Bell, Mark

(57) **Abstract**

A mechanism for designing a programmable logic architecture capable of implementing a plurality of predefined applications is provided, based on the definition of netlists of FPGA architecture primitives for each application, and then determining the common resource requirement represented by those netlists, as the basis for the determination of a preliminary routing resource estimation and the generation of a candidate architecture with reference to the baseline resource requirement and the preliminary routing resource estimation. A placement and routing solution for each application within the candidate architecture is attempted, which may be performed on the basis of the candidate architecture mapped onto a predefined statistical or real model of a standard silicon implementation. If a satisfactory placement and routing solution is found, the architecture is adopted, or otherwise the routing resource estimation, can be increased and a new attempt made to find a routing and placement solution.

## Description

### Field of the invention

The present invention relates to programmable logic architectures, and more particularly to Field Programmable Gate Array (FPGA) architectures.

### Background of the invention

FPGAs are a type of Programmable Logic Device (PLD). They are generally based on an architecture of one or more standard programmable logic block types, a large number of which are arranged together to implement various functions.

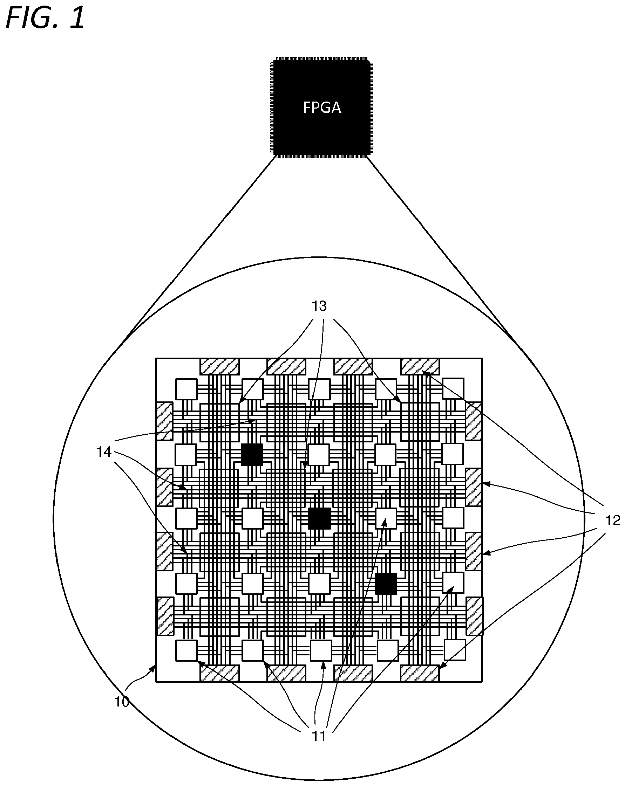

Figure 1 shows schematically an example of an FPGA architecture as known in the state of the art.

As shown in figure 1, an FPGA architecture 10 comprises a number of logic blocks 11, for example as described above. The architecture also comprises a number of input/output ports 12. Connecting these logic blocks 11 and input/output ports 12 are a number of tracks 14. The number of parallel tracks is generally the same between each logic block, and as such is a general characteristic of a particular FPGA design, referred to as interconnection size. At junction points of these tracks are provided a number of programmable routing areas 13, which may also be referred to as switch boxes. In these programmable routing areas there are provided switches which can selectively connect any pair of intersecting tracks, under the control of a logical value stored in a bit cell memory connected with each switch. The bit cell memory values are set at system start up from a non volatile memory. Accordingly, by setting the values in the switch memories as required, any connections of any logic block can be coupled to those of any other logic block, or any input/output port 12. Similarly any one input/output port may be connected to any other input/output port. Thus, by properly configuring the memory units to define the operation of each logic block, and the switch memories 13 to establish appropriate connections between the logic blocks, any desired functionality can be implemented.

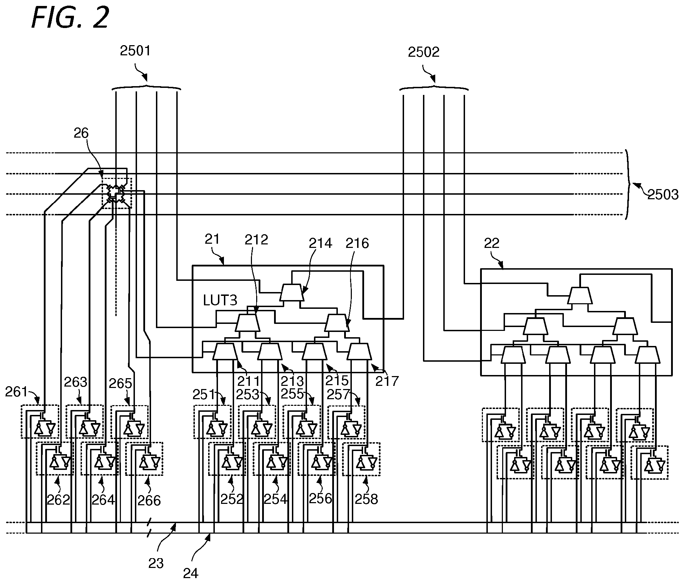

Figure 2 shows further detail of elements of an FPGA architecture as known in the state of the art.

The elements shown in figure 2 constitute a representative example of a partial implementation of parts of the functionality described above with respect to figure 1.

As shown in figure 2, there is provided a first Look Up Table (LUT) 21, and a second Look Up Table (LUT) 22, and a number of further LUTs (not shown). Each LUT thus corresponds to a logic block 11 as described in figure 1, although in real FPGA implementations each logic block will generally comprise more than one LUT, and possibly other circuits extending or enhancing the functionality of the logic block, such that logic block of different types may be defined with characteristic functionality. The first LUT 21 comprises seven, two input multiplexers 211, 212, 213, 214, 215, 216, 217 respectively. The second LUT and further LUTs are configured similarly. These multiplexers are arranged in a cascading manner with three rows so as to constitute an 8 input multiplexer, the output of which constitutes the output of the LUT. The first row of multiplexers (211, 213, 215 and 217) in each cascade arrangement both have a total of eight inputs. These eight inputs constitute the programming inputs of the first LUT 21. The selection inputs of each row are ganged together, to constitute the three data inputs of the LUT. The data inputs and data output of the first LUT are connected to a set of tracks 2501, 2502. The inputs and outputs of the second and further LUTs are connected correspondingly to a network of further tracks (not shown). Conventionally a LUT with 3 data inputs in this manner is referred to as a "LUT3". This is generally termed the LUT size, and the number of LUTs of each size required to implement a particular operation is a basic element in designing an FPGA to implement that operation. Each of the eight programming inputs of the first LUT 21 is connected to a respective bit cell memory 251, 252, 253, 254, 255, 256, 257, 258. Corresponding bit cells provide the configuration inputs of the second LUT 22, and the other LUTs provided in the system (not shown). In operation, these bit cell memories 251, 252, 253, 254, 255, 256, 257, 258 provide a constant predetermined logical value to each of the eight programming inputs of each LUT. The content of each bit cell memory is shown schematically as comprising a latch built of two inverters, each receiving the output of the other, with a transistor switch, switched by a respective word line, provided to enable the selective output of the value on the output of one of the inverters in the latch to a bit line connected to a respective configuration input of the LUT 217, and also to a respective data line by means of which the value of the latch may be set. The bit line of each bit cell memory 251, 252, 253, 254, 255, 256, 257, 258 is connected to a selection bus 23, and the word line of each bit cell memory 251, 252, 253, 254, 255, 256, 257, 258 is connected to a data bus 24. During an initiation phase for the circuit, each bit cell memory 251, 252, 253, 254, 255, 256, 257, 258 is addressed in turn, and the desired value set to the latch in question. The logical behaviour of the LUT in response to any binary value on its three data inputs can thus be defined as required. This is the underlying basic concept of FPGA technology. It will be appreciated however that the functions that a single logic block comprising two LUT3s can implement are limited, however by interconnecting a number of suitably configured LUTs as described above, any arbitrary combinatorial function can be implemented. This interconnection is achieved through a programmable interconnection of the data channels 2501, 2502, and further channels (not shown) carrying data from other LUTs. As shown whilst channels 2501, 2502 are arranged vertically, there is provided a further channel 2503 intersecting channels 2501, 2502. At the intersection of respective lines of channels 2501 and 2503 is provided a programmable switching unit 26. Considering that the intersection of the two lines constitutes a total of four connections at the switching unit, the switching unit comprises 6 transistor switches, arranged to make or break a connection between any two of these four connections. Each of these transistor switches is set to be open or closed by a value received from a respective bit cell memory 261, 262, 263, 264, 265, 266. Further such programmable switching units, with corresponding bit cell memories are provided at many or all track intersections (not shown). These bit cell memories 261, 262, 263, 264, 265, 266 as shown are identical to the bit cell memories 251, 252, 253, 254, 255, 256, 257, 258, and connected to the same selection bus 23 and data bus 24, so that during an initiation phase for the circuit, both the LUT bit cell memories and switch bit cell memories may be addressed in turn, and the desired value set to the latch in question, so that the behaviour of each LUT, and its connections to any other LUT may be configured as required.

While the flexibility of a generic FPGA has the advantage of being able to implement the widest range of applications, this flexibility often comes at the cost of silicon area penalty, higher power consumption and lower performance in any given application compared to ASIC or physical implementation, while some degree of optimisation of the design of the FPGA itself could offer significant improvements if designed with that application in mind. On the other hand, excessive optimisation for one application will tend to negate the particular advantages of the FPGA approach.

A number of semi-automated tools exist for the development of FPGAs for a specified application. US 7051313 or US 6631510 describe an "architecture generation engine" operative with a CAD system to implement circuits into PLD architectures and to evaluate performances of different architectures.US7051313B1 in particular presents an architecture generation engine operative with a CAD (Computer-Aided Design) system to implement circuits into PLD architectures and to evaluate performances of different architectures. The architecture generation engine converts a high level, specified description of a PLD architecture into a detailed, complete PLD architecture database that can be used by a CAD toolset to map a circuit netlist into a PLD. The architecture generation engine also enables performance evaluation of a wide variety of PLD architectures for given benchmark circuits. The articles by Darren Cronquist et al. entitled "Emerald-An Architecture-Driven Tool Compiler for FPGAs", ACM Symp. on FPGAs, 1996, pp. 144-150 and by Vaughn Betz et al., entitled "Architecture and CAD for Deep-Submicron FPGAs", Mar. 1999, Chapters 4, 5, 6 and 7, Kluwer Academic Publishers provide further discussion of these subjects.

The architecture generation engine converts a high level, easily specified description of a PLD architecture into a highly detailed, complete PLD architecture database that can be used by a CAD toolset to map a circuit netlist into a PLD. The architecture generation engine also enables performance evaluation of a wide variety of PLD architectures for given benchmark circuits.

Meanwhile, it is desirable to develop a mechanism for the design of programmable logic architectures on the basis of a plurality of known applications which can provide optimised performance for each, whilst benefiting from the flexibility of FPGA technologies by encompassing all.

### Summary of the invention

In accordance with the present invention in a first aspect there is provided a method for defining a programmable logic architecture supporting a plurality of applications in a specified semiconductor process. The method comprises the steps of:
transforming a respective functional definition of each of the plurality of applications into a respective netlist of FPGA architecture primitives;
for each of a plurality of FPGA architecture primitive type resources, identifying optimal resource requirements of each netlist;
for each of the plurality of FPGA architecture primitive type resources, identifying a baseline resource requirement equal to the largest minimal resource requirement determined for the netlists;
determining a respective application routing resource estimation for each netlist;
determining a preliminary routing resource estimation on the basis of the application routing resource estimation for the netlists;
generating a candidate architecture on the basis of the baseline resource requirement for each resource and the preliminary routing resource estimation;
performing placement and routing for each netlist within the candidate architecture; and
in a case where the placement and routing operation fails, generating a further candidate architecture with a revised routing resource estimation, wherein the revised routing resource estimation is greater than the preliminary routing resource estimation.

In a development of the first aspect, the steps of generating a further candidate architecture with a revised routing resource estimation and performing placement and routing for each netlist within the candidate architecture may be repeated until the placement and routing operation succeeds.

In a further development of the first aspect, the method may comprise the further step of determining a signal delay value for the FPGA architecture primitives with regard to a delay model for the FPGA architecture primitives for the semiconductor process.

In a further development of the first aspect, the preliminary routing resource estimation may be equal to the largest respective Rent coefficient of the netlists.

In a further development of the first aspect, the coefficient may be between 0.7 and 1.

In a further development of the first aspect, the method may comprise the further steps of calculating a maximum working frequency for the respective placement and routing result for each netlist for the semiconductor process;
comparing the maximum working frequency for the respective placement and routing result for each netlist with a threshold, and
in a case where any maximum working frequency for the respective placement and routing result for each netlist does not exceed the threshold, generating a further candidate architecture with a revised routing resource estimation, wherein the revised routing resource estimation is greater than the preliminary routing resource estimation in a case where the placement and routing operation failed, and the revised routing resource estimation is smaller than the preliminary routing resource estimation in a case where the placement and routing operation succeeded.

In a further development of the first aspect, the steps of generating a further candidate architecture with a revised routing resource estimation, performing placement and routing for each netlist within the candidate architecture and comparing the maximum working frequency for the respective placement and routing result for each netlist with the threshold, may be repeated until in no maximum working frequency for the respective placement and routing result for each netlist exceeds the threshold.

In a further development of the first aspect, the FPGA architecture primitive type resources may comprise any one of a Boolean function, a Look-Up Table (LUT), a sequential logic function, an arithmetic calculation function, a memory block, a multiplexer, a demultiplexer, a counter, a Finite-State Machine (FSM), a Multiplier-Accumulators (MAC), an Arithmetic Logic Units (ALU), a Fast Fourier Transforms (FFT), a Discrete Wavelet Transforms (DWT), a Cyclic Redundancy Check (CRC), a Finite Impulse Response (FIR), an Infinite Impulse Response (IIR), a hash function or a cryptographic function.

In a further development of the first aspect, the selection of elements from the Primitives Library may be constrained by a predefined set of Architecture Parameters which may permit or exclude certain primitives from use in the candidate architecture.

In a further development of the first aspect, the method may comprise the further step prior to the step of generating the candidate architecture, of identifying a functionality common to the plurality of applications and defining a new primitive corresponding to the functionality.

In a further development of the first aspect, the step of generating a candidate architecture may comprise incorporating the new primitive in the candidate architecture.

In a further development of the first aspect, the step of performing placement and routing for each netlist may comprise mapping the candidate architecture to a predefined statistical model of a standard silicon implementation.

In a further development of the first aspect, a plurality of primitive implementations may be defined for one or more FPGA architecture primitive type resources, each primitive implementation being associated with a plurality of design consideration values, and where each application is associated with a design consideration hierarchy, and wherein the step of transforming a respective functional definitions of each of the plurality of applications into a netlist of FPGA architecture primitives comprises generating a plurality of the netlists based on alternative combinations of the primitive implementations for the FPGA architecture primitives, and selecting whichever netlist comprises primitive implementations which aggregate design consideration values best correspond to the design consideration hierarchy.

In accordance with the present invention in a second aspect there is provided a computer program adapted to implement the steps of the first aspect.

In accordance with the present invention in a third aspect there computer readable medium incorporating the computer program of the second aspect.

In accordance with the present invention in a fourth aspect there is provided an apparatus for defining a programmable logic architecture supporting a plurality of applications in a specified semiconductor process, the device comprising means adapted to transform a respective functional description of each of the plurality of applications into a netlist of FPGA architecture primitives;
identify optimal resource requirements of each netlist for each of a plurality of architecture primitive type resources,
identify a baseline resource requirement equal to the largest minimal resource requirement determined for the netlists for each of the plurality of resources,
determine a respective application resource requirement for each netlist,
determine a preliminary routing resource estimation on the basis of the application resource requirements,
generate a candidate architecture on the basis of the baseline resource requirement for each resource and the preliminary routing resource estimation;
perform placement and routing for each netlist within the candidate architecture; and
in a case where the placement and routing operation fails, to generate a further candidate architecture with a revised routing resource estimation, wherein the revised routing resource estimation is greater than the preliminary routing resource estimation.

### Brief Description of the Drawings

The above and other advantages of the present invention will now be described with reference to the accompanying drawings, in which:
Figure 1 shows schematically an example of an FPGA architecture as known in the state of the art;
Figure 2 shows further detail of elements of an FPGA architecture as known in the state of the art;
Figure 3 presents a set of entities in accordance with an embodiment;
Figure 4 shows the steps of a method for defining a programmable logic architecture supporting a plurality of applications in a specified semiconductor process in accordance with an embodiment;
Figure 5 shows the steps of a method for defining a programmable logic architecture supporting a plurality of applications in a specified semiconductor process in accordance with a further embodiment; and
Figure 6 shows a generic computing system suitable for implementation of embodiments of the invention.

### Detailed description

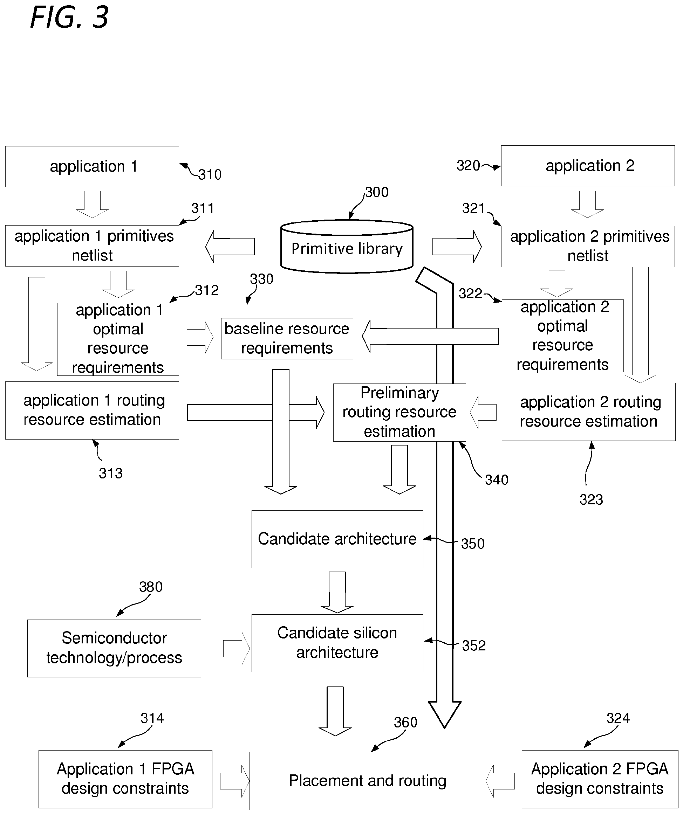

Figure 3 presents a set of entities in accordance with an embodiment. As shown in figure 3, there is provided a first application 310 and a second application 320. These take the form of functional descriptions of specific applications which may be implemented for example on an FPGA device, for example in a Hardware Description Language (HDL) such as Verilog, SystemVerilog, VHDL, or the like, or High-Level Synthesis (HLS) language such as C, C++, SystemC, or the like, or otherwise. As such, these are explicit, formal representations of the functions to be implemented by the respective applications 310, 320. In accordance with the present embodiment, an application primitives netlist 311, 321 is generated on the basis of the first application 310 and second application 320 respectively. The primitives in question here may correspond to any of the low level building blocks that could be used to define programmable logic features, such as Boolean functions, Look-Up Tables (LUT), sequential logic functions, arithmetic calculation functions or memory blocks. Look-Up Tables include any combinational logic functions of any size, sequential logic functions includes any registers, flip-flops or latches, arithmetic calculation functions includes any adders, subtractors, multipliers, dividers or shifters and memory blocks includes any memories, First-In First-Out (FIFO) or Last-In First-Out (LIFO). The primitives may also include more advanced standard function blocks such as multiplexers/demultiplexers, counters, Finite-State Machines (FSM), Multiplier-Accumulators (MAC), Arithmetic Logic Units (ALU), Fast Fourier Transforms (FFT), Discrete Wavelet Transforms (DWT), Cyclic Redundancy Check (CRC), Finite Impulse Response (FIR), Infinite Impulse Response (IIR), hash functions (SHA, MD5...), cryptographic functions (DES, AES, RSA...), etc. The set of primitives on the basis of which the primitive netlists are defined are drawn from a Primitives Library 300. The set of primitives is drawn in the first instance from the various low level building blocks provided by the programmable logic features to be used. In a second instance, primitives may be defined based on combinations of low level building blocks configured to provide advanced functions for such as listed above, for example in the form of a set of logic cells, which are the logical equivalent of a four-input LUT (LUT4) and a flip-flop. The selection of elements from the Primitives Library 300 may be constrained by a predefined set of Architecture Parameters (not shown) which may permit or exclude certain primitives. For example, the Architecture Parameters may impose the use of a particular LUT sizes, authorize, or exclude, the use of certain advanced standard function blocks as discussed above, and so on. In some cases the number of instances of a particular primitive to be included may be specified by the user. The primitive netlist for each application thus constitutes an enumeration of the various primitives needed to implement the respective application, and the requisite connections between them. Each application primitives netlists 311, 321 is thus a formal representation of the application in much the same way as the application definition 310, 320, itself, but couched in terms of FPGA architecture primitives.

Many FPGA devices offer dedicated hardware for common functions. For example, FPGA devices often integrate memory, mathematical functions, signal processing functions, and the like as dedicated on-chip hardware. As such, some of the primitive types may be implemented in the candidate architecture in programmable parts of the FPGA, and other primitive types may be implemented in the candidate architecture in hard-wired parts of the FPGA.

In some embodiments, functionality common to two or more applications may be identified, and defined as one or more new primitives corresponding to the functionality. This may require a separate process which analyzes applications to design the preferred standard implementation of the function in question based on the capabilities of the architecture. These new primitives may be used in the definition of the primitives netlists, and may also be added to the primitive library 300. Furthermore, any such new primitives can be used in defining the candidate architecture.

For each of these primitives netlists, it is then possible to analyze and determine the optimal FPGA resources 312, 322 implied by that netlist. Specifically, an FPGA design will typically call for a number of LUTs of different sizes, and possibly one or more of any of the other primitive types mentioned above. By comparing the minimal resource requirements 312, 322 of each application 310, 320, it is possible to determine baseline resource requirements 330, representing the resources required to implement both applications (non-concurrently) in the same architecture. The definition of the baseline resource requirements is susceptible to considerable optimization- in some cases it may be possible to go beyond simply identifying the superset of the contents of each minimal resource requirement, to identify alternative configurations meeting the requirements of each requirement set. For example, the minimal resource requirement for application 1 may call for 95 LUT3s and 5 LUT4s, while the minimal resource requirement for application 2 may call for 100 LUT3s. Instead of specifying 100 LUT3s and 5LUT 4s, the baseline resource requirement might specify 110 LUT3s, on the basis that 15 LUT3s can be ganged together to build 5 LUT4s, or 95 LUT3s and 5 LUT4s, on the basis that a LUT4 can also provide the functionality of a LUT3.

In accordance with certain embodiments, this step of optimization may be performed with reference to a hierarchy of design considerations. This hierarchy may include any design consideration that may be defined for a particular design scenario, such as for example size, genericity (i.e. the extent to which the design is based on standard, generic components, operating frequency, power consumption, homogeneity (the range of different components used in the design), operating speed, and the like). The design priorities reflected by this hierarchy may be specified by a user. For any given primitive, a number of implementation solutions may be defined with different characteristics in terms of these design considerations, which may be stored in association with the representations of the primitives in the primitive library 300. At the optimization step, the implementation of each primitive may be selected as whichever implementation best corresponds to the hierarchy of design considerations. Where a plurality of applications are to be implemented by a given design, an average hierarchy of design considerations may be used combining hierarchies defined for each application. This may be a weighted average, giving more or less importance to the design consideration hierarchy of each application. Certain applications may have no specified design consideration hierarchy, or the design consideration hierarchy of certain applications may be disregarded. One application may be designated as a main application, with the design consideration hierarchies of all other applications being ignored, or only used to select between solutions which give equal performance on the basis of the design consideration hierarchy of the main application. This in turn suggests the number of logic blocks of specified type, or advanced standard function blocks, and what they should contain.

Furthermore, the application primitives netlists 311, 321 can be analyzed to determine respective routing resource estimations 313, 323. These are estimations of routing resources such as the interconnection size, that is, the channel size required to ensure communications between the logic block of the architecture as suggested by the routing resource requirement for each application. Routing resource estimations may also include interconnection/switch box topology, and other architecture constraints for example as mentioned above. In the case of a hierarchical architecture, further routing resources include the number of hierarchical levels and their size at each level.

In a case where a plurality of different types of routing resource are considered as part of the routing resource estimations, the routing resource estimation may be expressed in an arbitrary routing resource unit, which may later be translated into specific combinations of the different types of resource available with reference to a routing resource conversion table. Each resource in the routing resource conversion table may be associated with one or more cost factors such as area, energy requirement, and the like, and whichever combination meets the routing resource requirement at the lowest cost is selected.

Routing resource estimations may be characterized by a coefficient which represents the Rent parameter reflecting the number of internal interconnections, of the application primitives netlists, which may typically fall between 0.7 and 1.

In some embodiments, the preliminary routing resource requirement 340 may be calculated as being equal to the largest coefficient of each application primitives netlist. The routing resource may then be constrained by a predefined set of Architecture Parameters (not shown) which may impose the use of a particular switch box topology, or a hierarchical architecture, the number of hierarchical levels in the architecture, and the like.

On the basis of the baseline resource requirements, the preliminary routing resource estimation and Architecture Parameter (not shown), it is now possible to generate a candidate architecture 350. The candidate architecture specifies exactly which components are found in the programmable logic architecture, and how they are interconnected together.

The candidate architecture 350 can now be considered in the context of an actual physical implementation, e.g. in terms of a silicon chip. Different approaches may be taken in this regard. In a first case, the candidate architecture may be mapped onto a predefined statistical model of a standard silicon implementation to obtain a Candidate Silicon Architecture Model 352. In practice this approach has been found generally to provide satisfactory results.

Alternatively, the candidate architecture can be fully translated into a Physical Silicon Architecture, by translating into a Register Transfer Level description, then through a Silicon Flow with reference to a specific Silicon Process 380. This provides a Physical Silicon Architecture on one hand, and a Silicon Architecture Model on the other.

In any case, the result is a Candidate Silicon Architecture Model 352, which reflects the physical characteristics of a statistical or real implementation of the Candidate Architecture 350 with sufficient fidelity to support the analyses of the following steps.

It is now possible to look for a placement and routing solution 360, specifying how the different components and interconnections called for by the candidate architecture 350 can be distributed across the circuits provided by the Candidate Silicon Architecture Model 352. If it proves possible to satisfactorily place all of the functions and route all of the necessary paths as specified by each application, with reference to the Primitives Library, as well as any further FPGA design constraints 314, 324, the Candidate Silicon Architecture Model 352, and so the Candidate Architecture 350, can be adopted as a programmable logic architecture suitable for the two applications. Generally, at this step operations may be performed to:
- Validate the candidate architecture in terms of whether each of the applications can properly function, that is to say, whether sufficient resources (either routing resources, or primitives) are available.
- Analyse performance of each application once mapped onto the candidate architecture, in terms for example of surface area/number of LUTs, Frequency and/or power consumption.
Otherwise a new candidate architecture may be generated, and a new placement and routing solution attempted. If no candidate architecture 350 can be found for a given set of baseline resource requirements 330 and preliminary routing resource estimation 340 for which a successful placement and routing solution 360 is available, the FPGA design constraints 314, 324 may be relaxed to open up further possibilities for placement and routing 360, until an acceptable solution is found.

FPGA design constraints 314, 324 may comprise by way of example frequency or delay limitations of the respective applications.

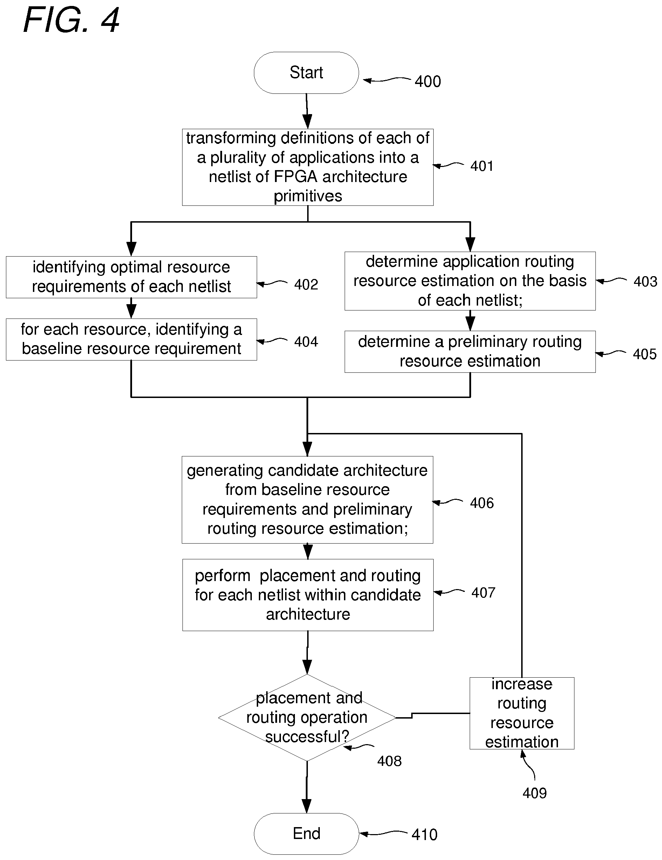

Figure 4 shows the steps of a method for defining a programmable logic architecture supporting a plurality of applications in a specified semiconductor process in accordance with an embodiment.

As shown in figure 4, the method starts at step 400 before proceeding to step 401 at which respective functional descriptions of each of the plurality of applications are transformed into a netlist of FPGA architecture primitives. As shown, the method next proceeds in parallel to steps 402 and 403. At step 402 optimal resource requirements of each netlist are identified for each of a plurality of architecture primitive type resources before proceeding to step 404. At step 404 a baseline resource requirement equal to the largest minimal resource requirement determined for the netlists is identified for each of plurality of resources before proceeding to step 406. Meanwhile at step 403 an application routing resource estimation of each netlist is determined for each application before proceeding to step 405 at which a preliminary routing resource estimation is determined on the basis of the application routing resource estimations for each netlist, before proceeding to step 406. At step 406 a candidate architecture, (corresponding for example to element 350 or 352 as discussed above) is generated on the basis of the baseline resource requirement for each resource and the preliminary routing resource estimation, before placement and routing for each netlist within the candidate architecture is performed. At step 408, the success of the placement and routing operation is assessed, and in a case where the placement and routing operation fails, a further candidate architecture is generated with a revised routing resource estimation greater than the preliminary routing resource estimation at step 409.In a case where the placement and routing operation succeeds the method terminates at step 410.

In certain embodiments, the steps of generating a further candidate architecture with a revised routing resource estimation and performing placement and routing for each netlist within the candidate architecture may be repeated until the placement and routing operation succeeds.

Thus, according to an optional development of the embodiment of figure 4 the method may comprise the further step of determining a signal delay value for the FPGA architecture primitives with regard to a delay model for the FPGA architecture primitives for the semiconductor process.

FPGA systems generally provide a variety of features for assisting clock propagation, with phase locked loops, multiplexers and buffers intended to deliver clean clock signals across the device. The physical limits of these devices impose a limit on the frequencies at which the device can operate. Although the clock frequency of a particular architecture is generally explicitly defined by the physical implementation, the real maximum working frequency of an application will depend on how effectively these features are mapped to a particular device. The maximum working frequency will generally be affected by the efficiency of the placement and routing and by the interconnection size and other routing resources adopted for the candidate architecture, and in a case where a particular architecture's maximum working frequency is insufficient, a new architecture may be generated with a different routing resource. Generally speaking, increasing routing resources will simplify the operation of the Placement and Routing algorithms, resulting in less congestion and fewer or shorter signal detours in the interconnection network. This in turn will generally support an increase in maximum working frequency, at the cost of increased architecture size/surface area. On the other hand, if no placement and routing solution is possible at a particular interconnection size or in compliance with other routing resource limitations, the interconnection size or other routing resource constraints will in any case be extended at step 409, for example by a predetermined increment to provide more possibilities.

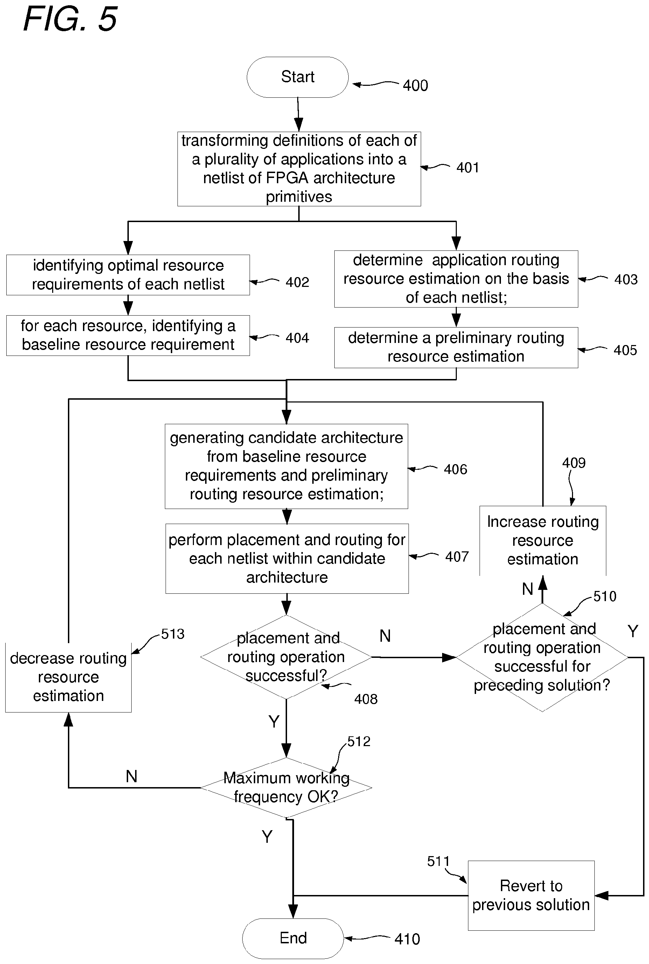

Figure 5 shows the steps of a method for defining a programmable logic architecture supporting a plurality of applications in a specified semiconductor process in accordance with a further embodiment.

As shown in figure 5, the method comprises the steps 400 to 408 substantially as described above. If at step 408 it is determined that the placement and routing operation has generated a viable solution, the method proceeds step 512 at which it is determined whether the maximum working frequency threshold is reached, that is to say, that whatever working frequency specified for the applications can be supported by the proposed solution. If the threshold is met, the method proceeds to step 410 as described above. Otherwise, the method proceeds to step 513, at which the routing resource estimation is decreased, before the method loops back to step 406 as described above. In accordance with the present embodiment, if at step 408 it is determined that the placement and routing operation was not successful, the method proceeds to step 510, at which the method considers whether the preceding configuration lead to a successful placement and routing solution. If the method determines that the previous attempt did lead to a successful placement and routing solution (even if it did not satisfy the working frequency requirement) the method reverts to the previous solution and terminates at step 410. Otherwise, the method proceeds to step 409 as described above.

Thus according to an optional development of the embodiment of figure 4 the method may comprise the further step of calculating a maximum working frequency for the respective placement and routing result for each netlist for the semiconductor process; comparing the maximum working frequency for the respective placement and routing result for each netlist with a threshold, and in a case where any maximum working frequency for the respective placement and routing result for each netlist does not exceed the threshold, generating a further candidate architecture with a revised routing resource estimation, wherein the revised routing resource estimation is greater than the preliminary routing resource estimation in a case where the placement and routing operation failed, and the revised routing resource estimation is smaller than the preliminary routing resource estimation in a case where the placement and routing operation succeeded.

As described with reference to figures 1 and 2, it is usual for routing of signals between logic blocks to be fixed by setting the values of various switch boxes positioned so as to selectively connect particular tracks so as to establish the desired signal path from one logic block to another. Each switch box has a significant series resistance and parasitic capacitance defined by the semiconductor technology used to implement the device, which will introduce a delay into digital signals. In a given implementation, the delay will depend on the length of the connections, and the number and type of switching devices along the path. For example, p type pass switches, n type pass switches and CMOS pass switches will have different characteristics, which will vary further depending of their dimensions, etc. Accordingly, the delays implied by a particular placement and routing solution can be calculated on the basis of the placement and routing solution itself taken together with the relevant physical characteristics of the semiconductor technology to be used in implementing the FPGA, and the components to be used. As such, a maximum delay value may be fixed for a placement and routing solution, such that any solution implying delay values exceeding the maximum value must be considered to fail test 512.

Furthermore, the steps of generating a further candidate architecture with a revised routing resource estimation, performing placement and routing for each netlist within the candidate architecture and comparing the maximum working frequency for the respective placement and routing result for each netlist with the threshold, may be repeated until the maximum working frequency for the respective placement and routing result for each netlist exceeds the threshold. In a case where a hierarchy of applications is defined, the steps may only need to be repeated until the maximum working frequency for the respective placement and routing result for certain applications having a higher importance in the hierarchy exceed the threshold.

It will be appreciated that the steps described with respect to figures 4 and 5 need not necessarily be performed in the sequence described. For example, which steps 402/404 on one hand and 403/405 are shown as being performed in parallel, they may be carried out one after another, and steps 402/404 may be performed before 403/405, or vice versa.

In accordance with certain embodiments there is thus provided a mechanism for designing a programmable logic architecture capable of implementing a plurality of predefined applications is provided, based on the definition of netlists of FPGA architecture primitives for each application, and then determining the common resource requirement represented by those netlists, as the basis for the determination of a preliminary routing resource estimation and the generation of a candidate architecture (corresponding for example to element 350 or 352 as discussed above) with reference to the baseline resource requirement and the preliminary routing resource estimation. A placement and routing solution for each application within the candidate architecture is attempted, which may be performed on the basis of the candidate architecture mapped onto a predefined statistical or real model of a standard silicon implementation. If a satisfactory placement and routing solution is found, the architecture is adopted, or otherwise the routing resource estimation can be increased and a new attempt made to find a routing and placement solution.

The disclosed methods can take form of an entirely hardware embodiment (e.g. FPGAs, ASICs), an entirely software embodiment (for example to control a system according to the invention) or an embodiment containing both hardware and software elements. Software embodiments include but are not limited to firmware, resident software, microcode, etc. The invention can take the form of a computer program product accessible from a computer-usable or computer-readable medium providing program code for use by or in connection with a computer or an instruction execution system. A computer-usable or computer-readable can be any apparatus that can contain, store, communicate, propagate, or transport the program for use by or in connection with the instruction execution system, apparatus, or device. The medium can be an electronic, magnetic, optical, electromagnetic, infrared, acoustic, electroacoustic, or semiconductor system (or apparatus or device) or a propagation medium.

For example, there may be provided an apparatus for defining an programmable logic architecture supporting a plurality of applications in a specified semiconductor process, the device comprising means adapted to transform a respective functional definition of each of the plurality of applications into a netlist of FPGA architecture primitives,
identify minimal resource requirements of each netlist for each of a plurality of architecture primitive type resources,
identify a baseline resource requirement equal to the largest minimal resource requirement determined for the netlists for each of the plurality of resources,
determine a respective application resource requirement for each said netlist,
determine a preliminary routing resource estimation on the basis of said application resource requirements,
generate a candidate architecture on the basis of the baseline resource requirement for each resource and the preliminary routing resource estimation,
perform placement and routing for each netlist within the candidate architecture, and
in a case where the placement and routing operation fails, to generate a further candidate architecture with a revised routing resource estimation, wherein the revised routing resource estimation is greater than the preliminary routing resource estimation.

Such an apparatus may be further adapted to implement any other steps or variants described above.

In some embodiments, the methods and processes described herein may be implemented in whole or part by a computing device. These methods and processes may be implemented by means of computer-application programs or services, an application-programming interface (API), a library, and/or other computer-program product, or any combination of such entities.

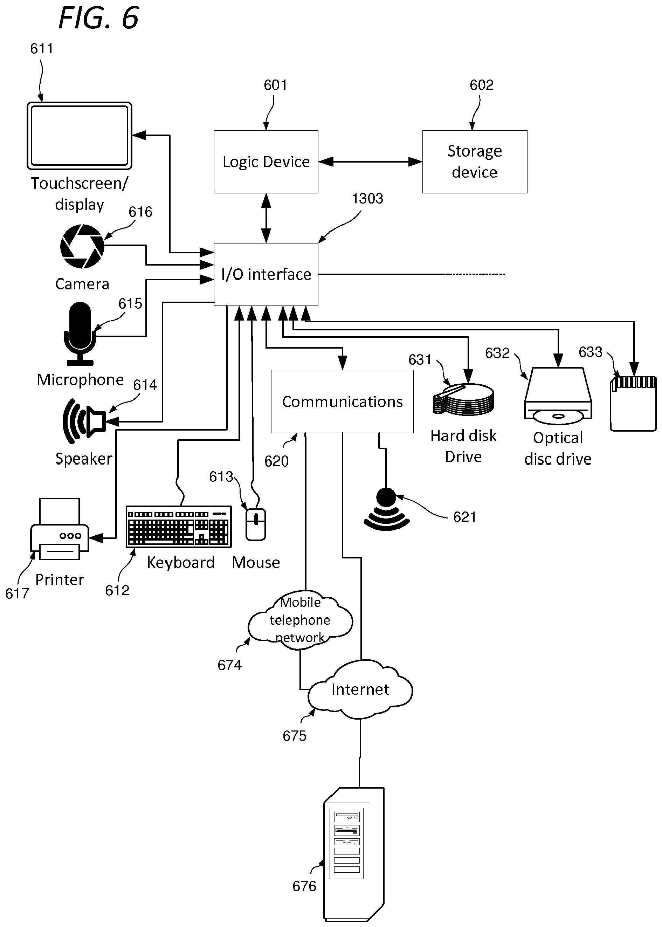

Figure 6 shows a generic computing system suitable for implementation of embodiments of the invention.

A shown in figure 6, a system includes a logic device 601 and a storage device 602. The system may optionally include a display subsystem 611, input subsystem 612, 613, 615, communication subsystem 620, and/or other components not shown.

Logic device 601 includes one or more physical devices configured to execute instructions. For example, the logic device 601 may be configured to execute instructions that are part of one or more applications, services, programs, routines, libraries, objects, components, data structures, or other logical constructs. Such instructions may be implemented to perform a task, implement a data type, transform the state of one or more components, achieve a technical effect, or otherwise arrive at a desired result.

The logic device 601 may include one or more processors configured to execute software instructions. Additionally or alternatively, the logic device may include one or more hardware or firmware logic devices configured to execute hardware or firmware instructions. Processors of the logic device may be single-core or multi-core, and the instructions executed thereon may be configured for sequential, parallel, and/or distributed processing. Individual components of the logic device 601 optionally may be distributed among two or more separate devices, which may be remotely located and/or configured for coordinated processing. Aspects of the logic device 601 may be virtualized and executed by remotely accessible, networked computing devices configured in a cloud-computing configuration.

Storage device 602 includes one or more physical devices configured to hold instructions executable by the logic device to implement the methods and processes described herein. When such methods and processes are implemented, the state of storage 602 device may be transformed-e.g., to hold different data.

Storage device 602 may include removable and/or built-in devices. Storage device 602 may comprise one or more types of storage device including optical memory (e.g., CD, DVD, HD-DVD, Blu-Ray Disc, etc.), semiconductor memory (e.g., RAM, EPROM, EEPROM, etc.), and/or magnetic memory (e.g., hard-disk drive, floppy-disk drive, tape drive, MRAM, etc.), among others. Storage device may include volatile, nonvolatile, dynamic, static, read/write, read-only, random-access, sequential-access, location-addressable, file-addressable, and/or content-addressable devices.

In certain arrangements, the system may comprise an interface 603 adapted to support communications between the Logic device 601 and further system components. For example, additional system components may comprise removable and/or built-in extended storage devices. Extended storage devices may comprise one or more types of storage device including optical memory 632 (e.g., CD, DVD, HD-DVD, Blu-Ray Disc, etc.), semiconductor memory 633 (e.g., RAM, EPROM, EEPROM, FLASH etc.), and/or magnetic memory 631 (e.g., hard-disk drive, floppy-disk drive, tape drive, MRAM, etc.), among others. Such extended storage device may include volatile, nonvolatile, dynamic, static, read/write, read-only, random-access, sequential-access, location-addressable, file-addressable, and/or content-addressable devices.

It will be appreciated that storage device includes one or more physical devices, and excludes propagating signals as such. However, aspects of the instructions described herein alternatively may be propagated by a communication medium (e.g., an electromagnetic signal, an optical signal, etc.), as opposed to being stored on a storage device.

Aspects of logic device 601 and storage device 602 may be integrated together into one or more hardware-logic components. Such hardware-logic components may include field-programmable gate arrays (FPGAs), application-specific integrated circuits (ASICs), application-specific standard products (ASSPs), systems-on-a-chip (SOC), and complex programmable logic devices (CPLDs), for example.

The term "program" may be used to describe an aspect of computing system implemented to perform a particular function. In some cases, a program may be instantiated via logic device executing machine-readable instructions held by storage device. It will be understood that different modules may be instantiated from the same application, service, code block, object, library, routine, API, function, etc. Likewise, the same program may be instantiated by different applications, services, code blocks, objects, routines, APIs, functions, etc. The term "program" may encompass individual or groups of executable files, data files, libraries, drivers, scripts, database records, etc.

In particular, the system of figure 6 may be used to implement embodiments of the invention.

For example a program implementing the steps described with respect to figures 2 or 3 may be stored in storage device 602 and executed by logic device 601. Any or all of the applications 310, 320, application primitives netlists 311, 321, optimal resource requirements 322, 312, baseline resource requirements 330, application routing resource estimation 313, 323, preliminary routing resource estimation 340, candidate architecture 350, semiconductor technology/process 380, candidate silicon architecture 352, FPGA design constraints 314,324, placement and routing 360, and primitive library 300, may be stored in storage device 602, or hard disk drive 631, optical disc drive 632, or flash memory device 633, etc. Some or all of these entities may be stored on server 676, and provided as required via the internet 675, LAN, or otherwise. A user may interact with such software implementations by means of a Graphical User Interface supported by the system of figure 6, and any intermediate software layers.

Accordingly the invention may be embodied in the form of a computer program.

It will be appreciated that a "service", as used herein, is an application program executable across multiple user sessions. A service may be available to one or more system components, programs, and/or other services. In some implementations, a service may run on one or more server-computing devices.

When included, display subsystem 611 may be used to present a visual representation of data held by storage device. This visual representation may take the form of a graphical user interface (GUI). As the herein described methods and processes change the data held by the storage device 602, and thus transform the state of the storage device 602, the state of display subsystem 611 may likewise be transformed to visually represent changes in the underlying data. Display subsystem 611 may include one or more display devices utilizing virtually any type of technology. Such display devices may be combined with logic device and/or storage device in a shared enclosure, or such display devices may be peripheral display devices.

When included, input subsystem may comprise or interface with one or more user-input devices such as a keyboard 612, mouse 613, touch screen 611, or game controller (not shown). In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, colour, stereoscopic, and/or depth camera for machine vision and/or gesture recognition; a head tracker, eye tracker, accelerometer, and/or gyroscope for motion detection and/or intent recognition; as well as electric-field sensing componentry for assessing brain activity.

When included, communication subsystem 620 may be configured to communicatively couple computing system with one or more other computing devices. For example, communication module of may communicatively couple computing device to remote service hosted for example on a remote server 676 via a network of any size including for example a personal area network, local area network, wide area network, or the internet. Communication subsystem may include wired and/or wireless communication devices compatible with one or more different communication protocols. As non-limiting examples, the communication subsystem may be configured for communication via a wireless telephone network 674, or a wired or wireless local- or wide-area network. In some embodiments, the communication subsystem may allow computing system to send and/or receive messages to and/or from other devices via a network such as the Internet 675. The communications subsystem may additionally support short range inductive communications 621 with passive devices (NFC, RFID etc).

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. A method for defining a programmable logic architecture supporting a plurality of applications in a specified semiconductor process, said method comprising the steps of:
transforming a respective functional definition of each of said plurality of applications into a respective netlist of FPGA architecture primitives;
for each of a plurality of FPGA architecture primitive type resources, identifying optimal resource requirements of each said netlist;
for each of said plurality of FPGA architecture primitive type resources, identifying a baseline resource requirement equal to the largest minimal resource requirement determined for said netlists;
determining a respective application routing resource estimation for each said netlist;
determining a preliminary routing resource estimation on the basis of said application routing resource estimation for said netlists;
generating a candidate architecture on the basis of said baseline resource requirement for each said resource and said preliminary routing resource estimation;
performing placement and routing for each said netlist within said candidate architecture; and
in a case where said placement and routing operation fails, generating a further candidate architecture with a revised routing resource estimation, wherein said revised routing resource estimation is greater than said preliminary routing resource estimation.

2. The method of claim 1 wherein said steps of generating a further candidate architecture with a revised routing resource estimation and performing placement and routing for each said netlist within said candidate architecture are repeated until said placement and routing operation succeeds.

3. The method of claim 1 or 2 comprising the further step of determining a signal delay value for said FPGA architecture primitives with regard to a delay model for said FPGA architecture primitives for said semiconductor process.

4. The method of any preceding claim wherein the preliminary routing resource estimation is equal to the largest respective Rent coefficient of said netlists.

5. The method of claim 4 wherein said coefficient is between 0.7 and 1.

6. The method of any preceding claim comprising the further steps of calculating a maximum working frequency for the respective placement and routing result for each said netlist for said semiconductor process;
comparing the maximum working frequency for the respective placement and routing result for each said netlist with a threshold, and
in a case where any said maximum working frequency for the respective placement and routing result for each said netlist does not exceed said threshold, generating a further candidate architecture with a revised routing resource estimation, wherein said revised routing resource estimation is greater than said preliminary routing resource estimation in a case where said placement and routing operation failed, and said revised routing resource estimation is smaller than said preliminary routing resource estimation in a case where said placement and routing operation succeeded.

7. The method of claim 6 wherein said steps of generating a further candidate architecture with a revised routing resource estimation, performing placement and routing for each said netlist within said candidate architecture and comparing the maximum working frequency for the respective placement and routing result for each said netlist with said threshold, are repeated until in no said maximum working frequency for the respective placement and routing result for each said netlist exceeds said threshold.

8. The method of any preceding claim wherein said FPGA architecture primitive type resources may comprise any one of a Boolean function, a Look-Up Table (LUT), a sequential logic function, an arithmetic calculation function, a memory block, a multiplexer, a demultiplexer, a counter, a Finite-State Machine (FSM), a Multiplier-Accumulators (MAC), an Arithmetic Logic Units (ALU), a Fast Fourier Transforms (FFT), a Discrete Wavelet Transforms (DWT), a Cyclic Redundancy Check (CRC), a Finite Impulse Response (FIR), an Infinite Impulse Response (IIR), a hash function or a cryptographic function.

9. The method of any preceding claim wherein the selection of elements from the Primitives Library may be constrained by a predefined set of Architecture Parameters which may permit or exclude certain said primitives.

10. The method of any preceding claim comprising a further step prior to said step of generating said candidate architecture, of identifying a functionality common to said plurality of applications and defining a new primitives corresponding to said functionality.

11. The method of claim 10 wherein said step of generating a candidate architecture comprises incorporating said new primitive in said candidate architecture.

12. The method of any preceding claim wherein said step of performing placement and routing for each said netlist comprises mapping said candidate architecture to a predefined statistical or real model of a standard silicon implementation.

13. The method of any preceding claim in which a plurality of primitive implementations are defined for one or more said FPGA architecture primitive type resources, each said primitive implementation being associated with a plurality of design consideration values, and where each said application is associated with a design consideration hierarchy, and wherein said step of transforming a respective functional definitions of each of said plurality of applications into a netlist of FPGA architecture primitives comprises generating a plurality of said netlists based on alternative combinations of said primitive implementations for said FPGA architecture primitives, and selecting whichever said netlist comprises primitive implementations which aggregate design consideration values best correspond to said design consideration hierarchy.

14. A computer program adapted to implement the steps of any of claims 1 to 13.

15. A computer readable medium incorporating the computer program of claim 14.

16. An apparatus for defining a programmable logic architecture supporting a plurality of applications in a specified semiconductor process, said device comprising means adapted to transform a respective functional description of each of said plurality of applications into a netlist of FPGA architecture primitives;
identify optimal resource requirements of each said netlist for each of a plurality of architecture primitive type resources,
identify a baseline resource requirement equal to the largest minimal resource requirement determined for said netlists for each of said plurality of resources,
determine a respective application resource requirement for each said netlist,
determine a preliminary routing resource estimation on the basis of said application resource requirements,
generate a candidate architecture on the basis of said baseline resource requirement for each said resource and said preliminary routing resource estimation;
perform placement and routing for each said netlist within said candidate architecture; and
in a case where said placement and routing operation fails, to generate a further candidate architecture with a revised routing resource estimation, wherein said revised routing resource estimation is greater than said preliminary routing resource estimation.
